# EUROPEAN PATENT APPLICATION

(11) **EP 4 675 922 A1**
(43) Date of publication of application: **07.01.2026**
(21) Application number: 25178526.7
(22) Date of filing: 23.05.2025
(51) Int. Cl.: H03K 3/3565

(54) **INVERTER CIRCUIT WITH DYNAMIC CROSSING POINT AND METHOD OF ADAPTIVELY ADJUSTING CROSSING POINT OF INVERTER CIRCUIT**

(30) Priority: 05.07.2024 US 202463667817 P; 08.05.2025 US 202519203149
(71) Applicant: Airoha Technology Corp., 300 Hsinchu City (TW)
(72) Inventor: WANG, Chen-Yu, 244 New Taipei City (TW)
(74) Representative: Hoefer & Partner Patentanwälte mbB

(57) **Abstract**

An inverter circuit (100) includes a first metal-oxide-semiconductor, MOS, transistor (M1), a second MOS transistor (M2), a tunable pull-up circuit (102), a tunable pull-down circuit (104), and a control circuit (106). The first MOS transistor (M1) has a control terminal configured to receive a first input signal (IN), a first connection terminal, and a second connection terminal. The second MOS transistor (M2) has a control terminal configured to receive the first input signal (IN), a first connection terminal, and a second connection terminal coupled to the second control terminal of the first MOS transistor (M1). The tunable pull-up circuit (102) is coupled between the first connection terminal of the first MOS transistor (M1) and a first reference voltage (VDD). The tunable pull-down circuit (104) is coupled between the first connection terminal of the second MOS transistor (M2) and a second reference voltage (GND). The control circuit (106) adaptively adjusts pull-up strength of the tunable pull-up circuit (102) and pull-down strength of the tunable pull-down circuit (104).

## Description

### CROSS REFERENCE TO RELATED APPLICATIONS

This application claims the benefit of U.S. Provisional Application No. 63/667,817, filed on July 5th, 2024. The content of the application is incorporated herein by reference.

### BACKGROUND OF THE INVENTION

### 1. FIELD OF THE INVENTION

The present invention relates to an inverter design, and more particularly, to an inverter circuit with a dynamic crossing point and a method of adaptively adjusting the dynamic crossing point of the inverter circuit.

### 2. DESCRIPTION OF THE PRIOR ART

A limiting amplifier (LA) can be used to amplify an output of a transimpedance amplifier (TIA) to a reliable level. Ideally, an output level of the LA is fixed regardless of an input level of the LA. For example, the LA may include a gain stage, an alternating current (AC) coupled stage, and one or more LA stages. However, an LA stage may include a slicer that receives an LA-stage input signal with a duty error resulting from the gain stage which transits TIA noise to the LA-stage input signal and/or a baseline wander resulting from the AC-coupled stage located after the gain stage. The slicer may be simply implemented using a complementary metal-oxide-semiconductor (CMOS) inverter. Thus, there is a need for an innovative inverter design which is capable of addressing the duty error issue and/or the baseline wander issue.

### SUMMARY OF THE INVENTION

One of the objectives of the claimed invention is to provide an inverter circuit with a dynamic crossing point and a method of adaptively adjusting the dynamic crossing point of the inverter circuit. An inverter circuit and a method according to the invention are defined in the independent claims. The dependent claims define preferred embodiments thereof.

According to a first aspect of the present invention, an exemplary inverter circuit is disclosed. The exemplary inverter circuit includes a first MOS transistor, a second MOS transistor, a tunable pull-up circuit, a tunable pull-down circuit, and a control circuit. The first MOS transistor has a control terminal configured to receive a first input signal of the inverter circuit, a first connection terminal, and a second connection terminal. The second MOS transistor has a control terminal configured to receive the first input signal of the inverter circuit, a first connection terminal, and a second connection terminal coupled to the second control terminal of the first MOS transistor. The tunable pull-up circuit is coupled between the first connection terminal of the first MOS transistor and a first reference voltage. The tunable pull-down circuit is coupled between the first connection terminal of the second MOS transistor and a second reference voltage. The control circuit is configured to adaptively adjust pull-up strength of the tunable pull-up circuit and pull-down strength of the tunable pull-down circuit.

According to a second aspect of the present invention, an exemplary method of adaptively adjusting a crossing point of an inverter circuit is disclosed. The exemplary method includes: receiving a first input signal of the inverter circuit at a control terminal of a first MOS transistor and a control terminal of a second MOS transistor; and adaptively adjusting pull-up strength of a tunable pull-up circuit and pull-down strength of a tunable pull-down circuit, wherein the tunable pull-up circuit is coupled between a first connection terminal of the first MOS transistor and a first reference voltage, the tunable pull-down circuit that is coupled between a first connection terminal of the second MOS transistor and a second reference voltage, and a second connection terminal of the first MOS transistor is coupled to a second connection terminal of the second MOS transistor.

These and other objectives of the present invention will no doubt become obvious to those of ordinary skill in the art after reading the following detailed description of the preferred embodiment that is illustrated in the various figures and drawings.

### BRIEF DESCRIPTION OF THE DRAWINGS

FIG. 1 is a diagram illustrating an inverter circuit operating under a first output state OUT=High according to an embodiment of the present invention.
FIG. 2 is a diagram illustrating an inverter circuit operating under a second output state OUT=Low according to an embodiment of the present invention.
FIG. 3 is a flowchart illustrating operations of the inverter circuit shown in FIG. 1 and FIG. 2 according to an embodiment of the present invention.
FIG. 4 is a diagram illustrating a comparison between a standard inverter (STD-INV) with a fixed X-point and the proposed dynamic crossing inverter (DX-INV) with a dynamic X-point.
FIG. 5 is a diagram illustrating another inverter circuit according to an embodiment of the present invention.

### DETAILED DESCRIPTION

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

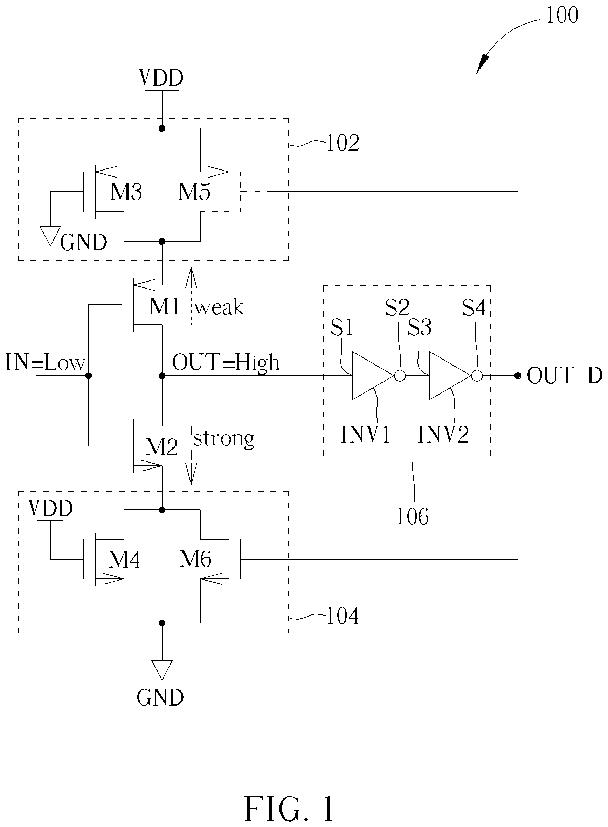

FIG. 1 is a diagram illustrating an inverter circuit operating under a first output state OUT=High according to an embodiment of the present invention. The inverter circuit 100 may be a part of a slice in a limiting amplifier. However, this is for illustrative purposes only, and is not meant to be a limitation of the present invention. In practice, any signal processing circuit using the inverter circuit 100 falls within the scope of the present invention. In this embodiment, the inverter circuit 100 is a dynamic crossing inverter (DX-INV) with a dynamic crossing point (X-point). As shown in FIG. 1, the inverter circuit 100 includes a metal-oxide-semiconductor (MOS) transistor (e.g., P-type metal-oxide-semiconductor (PMOS) transistor) M1, a MOS transistor (e.g., N-type metal-oxide-semiconductor (NMOS) transistor) M2, a tunable pull-up circuit 102, a tunable pull-down circuit 104, and a control circuit 106. The MOS transistor M1 has a control terminal (e.g., gate terminal) configured to receive an input signal IN of the inverter circuit 100, a first connection terminal (e.g., source terminal), and a second connection terminal (e.g., drain terminal). The MOS transistor M2 has a control terminal (e.g., gate terminal) configured to receive the input signal IN of the inverter circuit 100, a first connection terminal (e.g., source terminal), and a second connection terminal (e.g., drain terminal) coupled to the second control terminal (e.g., drain terminal) of the MOS transistor M1. Hence, an output signal OUT is generated at second connection terminals (e.g., drain terminals) of MOS transistors M1 and M2.

The tunable pull-up circuit 102 is coupled between the first connection terminal (e.g., source terminal) of the MOS transistor M1 and a first reference voltage (e.g., supply voltage VDD). The tunable pull-down circuit 104 is coupled between the first connection terminal (e.g., source terminal) of the MOS transistor M2 and a second reference voltage (e.g., ground voltage GND). The control circuit 106 is configured to adaptively adjust pull-up strength of the tunable pull-up circuit 102 and pull-down strength of the tunable pull-down circuit 104.

In this embodiment, the tunable pull-up circuit 102 includes MOS transistors (e.g., PMOS transistors) M3 and M5 connected in parallel. The MOS transistor M3 has a control terminal (e.g., gate terminal) coupled to the second reference voltage (e.g., ground voltage GND), a first connection terminal (e.g., source terminal) coupled to the first reference voltage (e.g., supply voltage VDD), and a second connection terminal (e.g., drain terminal) coupled to the first connection terminal (e.g., source terminal) of the MOS transistor M1. The MOS transistor M5 has a control terminal (e.g., gate terminal) configured to receive a control signal OUT_D, a first connection terminal (e.g., source terminal) coupled to the first reference voltage (e.g., supply voltage VDD), and a second connection terminal (e.g., drain terminal) coupled to the first connection terminal (e.g., source terminal) of the MOS transistor M1. Since the MOS transistor M3 is biased by the ground voltage GND, it is turned on to provide a constant resistance value. An on/off status of the MOS transistor M5 is adaptively controlled based on a logic level of the control signal OUT_D.

The tunable pull-down circuit 104 includes MOS transistors (e.g., NMOS transistors) M4 and M6. The MOS transistor M4 has a control terminal (e.g., gate terminal) coupled to the first reference voltage (e.g., supply voltage VDD), a first connection terminal (e.g., source terminal) coupled to the second reference voltage (e.g., ground voltage GND), and a second connection terminal (e.g., drain terminal) coupled to the first connection terminal (e.g., source terminal) of the MOS transistor M2. The MOS transistor M6 has a control terminal (e.g., gate terminal) configured to receive the control signal OUT_D, a first connection terminal (e.g., source terminal) coupled to the second reference voltage (e.g., ground voltage GND), and a second connection terminal (e.g., drain terminal) coupled to the first connection terminal (e.g., source terminal) of the MOS transistor M2. Since the MOS transistor M4 is biased by the supply voltage VDD, it is turned on to provide a constant resistance value. An on/off status of the MOS transistor M6 is adaptively controlled based on a logic level of the control signal OUT_D.

In this embodiment, the control circuit 106 may generate the control signal OUT_D needed for achieving a dynamic X-point. For example, the control circuit 106 may be implemented using inverters INV1 and INV2 connected in series. The inverter INV1 is configured to receive a first inverter input signal S1 derived from the output signal OUT (e.g., S1=OUT), and generate a first inverter output signal S2 according to the first inverter input signal S1 (i.e., S2 = S̅1̅). The inverter INV2 is configured to receive a second inverter input signal S3 derived from the first inverter output signal S2 (e.g., S3=S2), and generate a second inverter output signal S4 according to the second inverter input signal S3 (i.e., S4 = S̅3̅), where the second inverter output signal S4 may act as the control signal OUT_D of both of the pull-up circuit 102 and the pull-down circuit 104.

Specifically, the control circuit 106 receives the output signal OUT generated at second connection terminals (e.g., drain terminals) of MOS transistors M1 and M2, and adjusts the pull-up strength and the pull-down strength according to the output signal OUT, where a logic level of the control signal OUT_D is the same as a logic level of the output signal OUT. In this embodiment, when the output signal OUT has a logic-high level (e.g., OUT=High) due to a logic-low level of the input signal IN, the MOS transistor M6 is turned on and the MOS transistor M5 is turned off. As shown in FIG. 1, the pull-up strength is lower than the pull-down strength, resulting in a lower X-point which can facilitate an output transition from 1 to 0. Hence, when a current input state is 0 and a next input state is 1, the X-point is set to a lower level due to the current input state 0, and a transition from a current output state 1 to a next output state 0 can be earlier due to earlier crossing under a lower X-point.

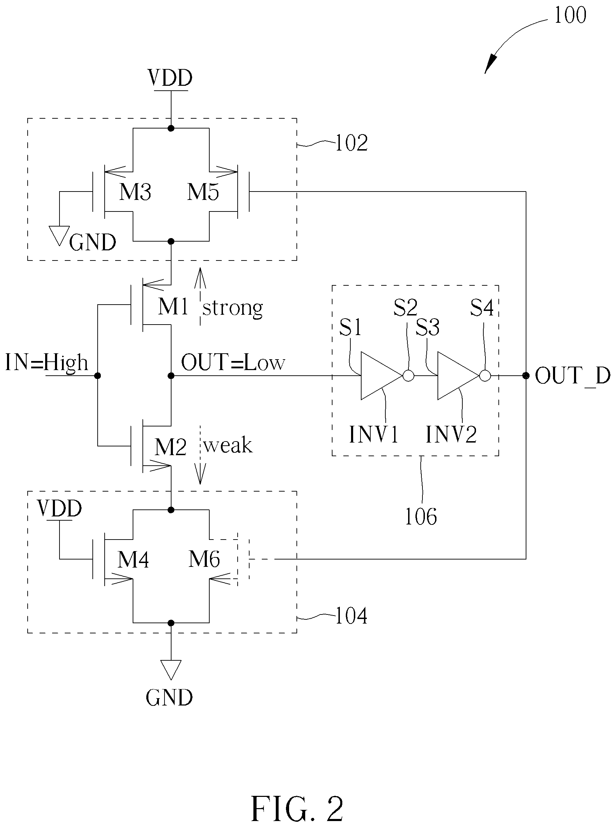

FIG. 2 is a diagram illustrating an inverter circuit operating under a second output state OUT=Low according to an embodiment of the present invention. In this embodiment, when the output signal OUT has a logic-low level (e.g., OUT=Low) due to a logic-high level of the input signal IN, the MOS transistor M6 is turned off and the MOS transistor M5 is turned on. As shown in FIG. 2, the pull-up strength is higher than the pull-down strength, resulting in a higher X-point which can facilitate an output transition from 0 to 1. Hence, when a current input state is 1 and a next input state is 0, the X-point is set to a high level due to the current input state 1, and a transition from a current output state 0 to a next output state 1 can be earlier due to earlier crossing under a higher X-point.

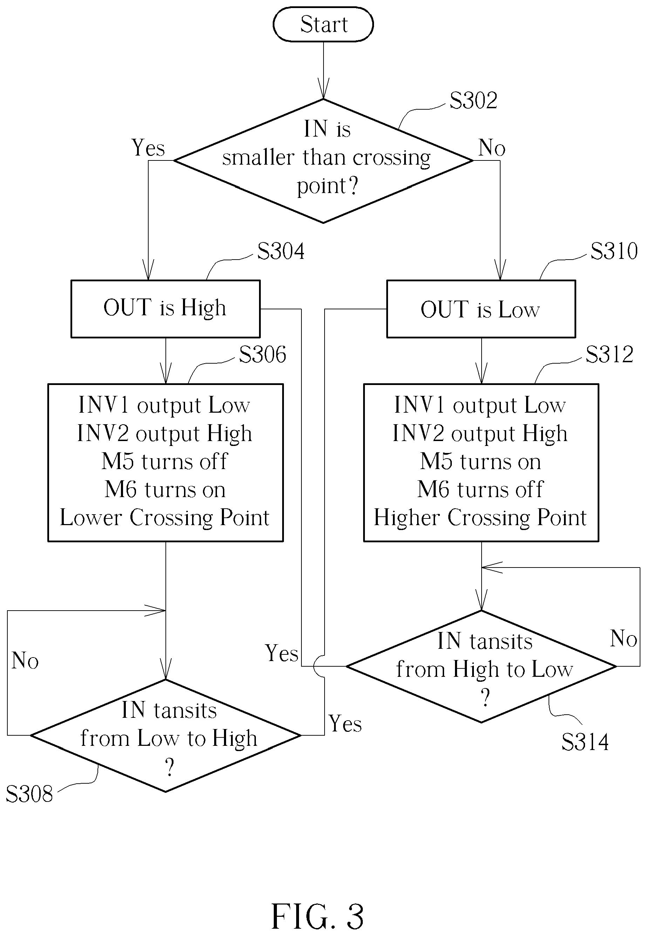

FIG. 3 is a flowchart illustrating operations of the inverter circuit 100 shown in FIG. 1 and FIG. 2 according to an embodiment of the present invention. At step S302, it is checked if a voltage level of the input signal IN is smaller than a current level of the X-point. If the voltage level of the input signal IN is smaller than the current level of the X-point, the output signal OUT has a logic-high level due to a transition from a logic-low level to the logic-high level (step S304). Hence, an output node of the inverter INV1 has a logic-low level, an output node of the inverter INV2 has a logic-high level, the MOS transistor M5 is turned off, the MOS transistor M6 is turned on, and the X-point decreases from the current level to a lower level (step S306). At step S308, it is checked to determine if the input signal IN has a transition from a logic-low level to a logic-high level. If the input signal IN does not have a transition from a logic-low level to a logic-high level, the current level (i.e., lower level) of the X-point remains unchanged, and the flow proceeds to step S308 again. If the input signal IN has a transition from a logic-low level to a logic-high level, the flow proceeds to step S310.

It should be noted that the flow proceeds to step S310 if the voltage level of the input voltage IN is not smaller than the current level of the X-point (step S302) or the input signal IN has a transition from a logic-low level to a logic-high level (step 308). At step S310, the output signal OUT has a logic-low level due to a transition from a logic-high level to the logic-low level. Hence, an output node of the inverter INV1 has a logic-high level, an output node of the inverter INV2 has a logic-low level, the MOS transistor M5 is turned on, the MOS transistor M6 is turned off, and the X-point increases from the current level to a higher level (step S312). At step S314, it is checked to determine if the input signal IN has a transition from a logic-high level to a logic-low level. If the input signal IN does not have a transition from a logic-high level to a logic-low level, the current level (i.e., higher level) of the X-point remains unchanged, and the flow proceeds to step S314 again. If the input signal IN has a transition from a logic-high level to a logic-low level, the flow proceeds to step S304. It should be noted that the flow proceeds to step S304 if the voltage level of the input voltage IN is smaller than the current level of the X-point (step S302) or the input signal IN has a transition from a logic-high level to a logic-low level (step 314).

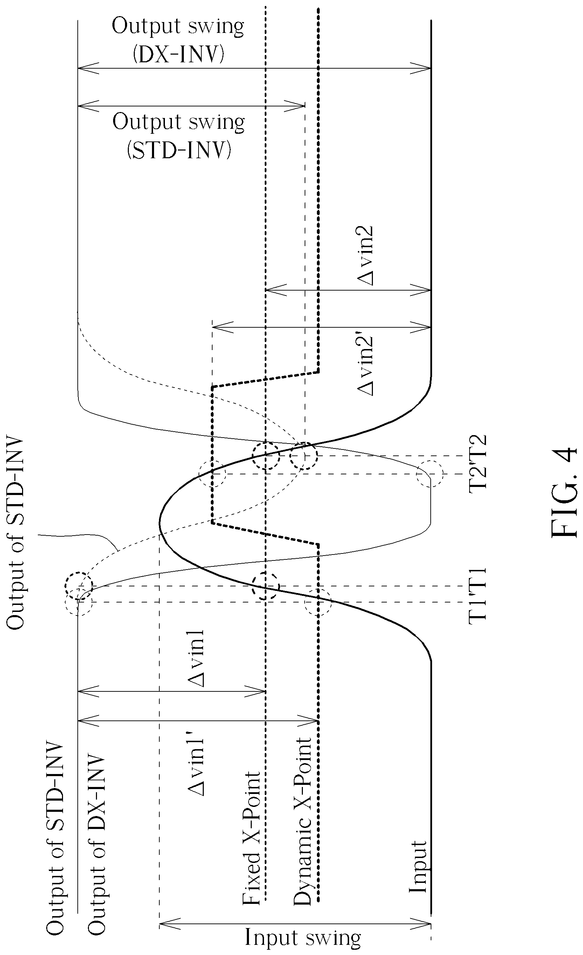

FIG. 4 is a diagram illustrating a comparison between a standard inverter (STD-INV) with a fixed X-point and the proposed dynamic crossing inverter (DX-INV) with a dynamic X-point. The proposed DX-INV can reduce the X-point (which refers to a specific time point at which the input signal IN has a transition to a predetermined voltage level from a logic-low level, causing the output signal OUT starts its transition from a logic-high level, and vice versa) to a lower level, such that 1→0 transition time T1' of the DX-INV output is earlier than the 1→0 transition time T1 of the STD-INV output. In addition, the proposed DX-INV can increase the X-point to a higher level, such that the 0→1 transition time T2' of the DX-INV output is earlier than the 0→1 transition time T2 of the STD-INV output. As shown in FIG. 4, a larger input difference Δvin1'/ Δvin2' (Δvin1' > Δvin1 & Δvin2' > Δvin2) of the DX-INV can produce an output swing larger than that of the STD-INV. Hence, the proposed DX-INV can make the transition of an unhealthy (means that an input swing is relatively small, not spanning from a logic-low level to a logic-high level) input signal easier. For example, the proposed DX-INV is capable of addressing the duty error issue encountered by the STD-INV.

The inverter circuit 100 shown in FIG. 1 is a dynamic crossing inverter (DX-INV) with a dynamic X-point. In some embodiments of the present invention, the dynamic crossing inverter (DX-INV) may act as an auxiliary circuit which is capable of assisting a standard inverter (STD-INV) in a level transition at an output node of the standard inverter (STD-INV).

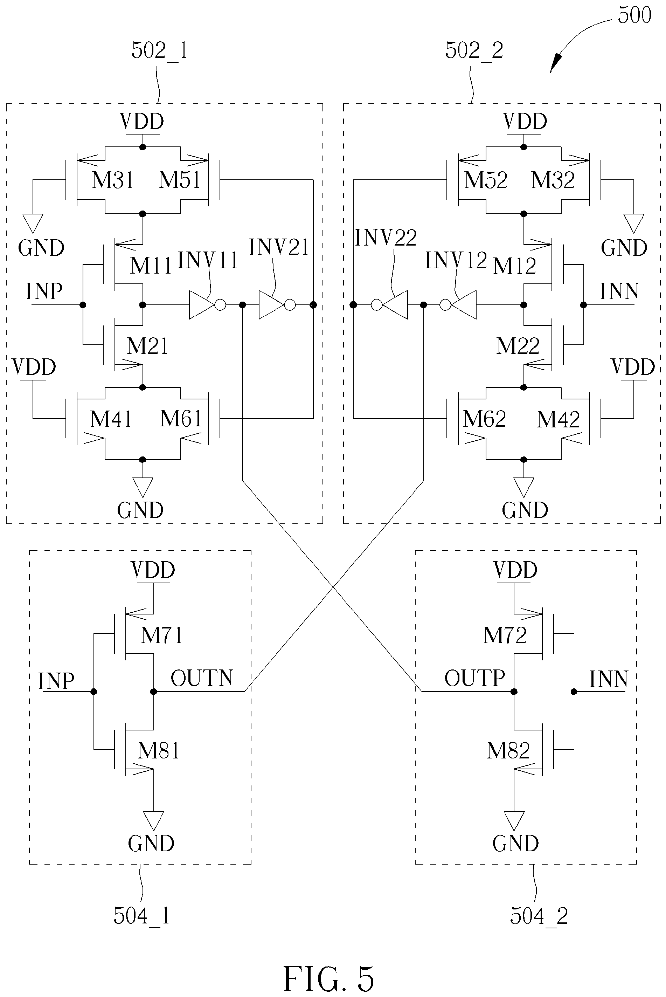

FIG. 5 is a diagram illustrating another inverter circuit according to an embodiment of the present invention. The inverter circuit 500 may be a part of a slice in a limiting amplifier. However, this is for illustrative purposes only, and is not meant to be a limitation of the present invention. In practice, any signal processing circuit using the inverter circuit 500 falls within the scope of the present invention. In this embodiment, the inverter circuit 500 is a cross-coupled dynamic crossing inverter. As shown in FIG. 5, the inverter circuit 500 includes a plurality of dynamic crossing inverters 502_1, 502_2 and a plurality of standard inverters 504_1, 504_2. Each of the dynamic crossing inverters 502_1, 502_2 may have a circuit structure the same as that of the inverter circuit 100 shown in FIG. 1. Hence, the dynamic crossing inverter 502_1 includes MOS transistors M11, M21, M31, M41, M51, M61 and inverters INV11, INV21, and the other dynamic crossing inverter 502_2 includes MOS transistors M12, M22, M32, M42, M52, M62 and inverters INV12, INV22. In this embodiment, the inverter circuit 500 is a differential circuit that receives a differential input consisting of a positive input signal INP and a negative input signal INN. Regarding the dynamic crossing inverter 502_1, the control terminals (e.g., gate terminals) of the MOS transistors M11 and M21 receive the positive input signal INP. Regarding the dynamic crossing inverter 502_2, the control terminals (e.g., gate terminals) of the MOS transistors M12 and M22 receive the negative input signal INN. As a person skilled in the art can readily understand principles of the dynamic crossing inverters 502_1 and 502_2 after reading above paragraphs directed to the inverter circuit 100, similar description is omitted here for brevity.

The standard inverters 504_1 and 504_2 have the same circuit structure. Regarding the standard inverter 504_1, a MOS transistor (e.g., PMOS transistor) M71 has a control terminal (e.g., gate terminal) configured to receive the positive input signal INP of the differential input, a first connection terminal (e.g., source terminal) coupled to the first reference voltage (e.g., supply voltage VDD), and a second connection terminal (e.g., drain terminal) coupled to an output node of the inverter INV12 included in the dynamic crossing inverter 502_2; and a MOS transistor (e.g., NMOS transistor) M81 has a control terminal (e.g., gate terminal) configured to receive the positive input signal INP of the differential input, a first connection terminal (e.g., source terminal) coupled to the second reference voltage (e.g., ground voltage GND), and a second connection terminal (e.g., drain terminal) coupled to the second connection terminal (e.g., drain terminal) of the MOS transistor M71 and the output node of the inverter INV12 included in the dynamic crossing inverter 502_2.

Regarding the standard inverter 504_2, a MOS transistor (e.g., PMOS transistor) M72 has a control terminal (e.g., gate terminal) configured to receive the negative input signal INN of the differential input, a first connection terminal (e.g., source terminal) coupled to the first reference voltage (e.g., supply voltage VDD), and a second connection terminal (e.g., drain terminal) coupled to an output node of the inverter INV11 included in the dynamic crossing inverter 502_1; and a MOS transistor (e.g., NMOS transistor) M82 has a control terminal (e.g., gate terminal) configured to receive the negative input signal INN of the differential input, a first connection terminal (e.g., source terminal) coupled to the second reference voltage (e.g., ground voltage GND), and a second connection terminal (e.g., drain terminal) coupled to the second connection terminal (e.g., drain terminal) of the MOS transistor M72 and the output node of the inverter INV11 included in the dynamic crossing inverter 502_1.

The standard inverters 504_1 and 504_2 serve as main paths of the inverter circuit 500. The dynamic crossing inverters 502_1 and 502_2 serve as auxiliary paths of the inverter circuit 500. The inverter circuit 500 with the proposed cross-coupled dynamic crossing inverter structure may be regarded as a voltage-mode slicer without any reset clock input. The cross-coupled connection allows the gain-enough dynamic crossing inverter 502_1 that has an earlier transition time due to a dynamic X-point to help the level transition at the output node of the standard inverter 504_2 that has a fixed X-point, and allows the gain-enough dynamic crossing inverter 502_2 that has an earlier transition time due to a dynamic X-point to help the level transition at the output node of the standard inverter 504_1 that has a fixed X-point. For example, the proposed cross-coupled dynamic crossing inverter is capable of addressing the duty error issue and the baseline wander issue encountered by the standard inverters.

Consider a case where the positive input signal INP has a Low-to-High level transition and the negative input signal INN has a High-to-Low level transition. An input of the inverter INV21 included in the dynamic crossing inverter 502_1 has a Low-to-High level transition that starts earlier than a Low-to-High level transition at an output of the standard inverter 504_2. An input of the inverter INV22 included in the dynamic crossing inverter 502_2 has a High-to-Low level transition that starts earlier than a High-to-Low level transition at an output of the standard inverter 504_1. In this way, the Low-to-High level transition at the output of the standard inverter 504_2 can be boosted by the dynamic crossing inverter 502_1, and the High-to-Low level transition at the output of the standard inverter 504_1 can be boosted by the dynamic crossing inverter 502_2.

Consider another case where the positive input signal INP has a High-to-Low level transition and the negative input signal INN has a Low-to-High level transition. An input of the inverter INV21 included in the dynamic crossing inverter 502_1 has a High-to-Low level transition that starts earlier than a High-to-Low level transition at an output of the standard inverter 504_2. An input of the inverter INV22 included in the dynamic crossing inverter 502_2 has a Low-to-High level transition that starts earlier than a Low-to-High level transition at an output of the standard inverter 504_1. In this way, the High-to-Low level transition at an output of the standard inverter 504_2 can be boosted by the dynamic crossing inverter 502_1, and the Low-to-High level transition at the output of the standard inverter 504_1 can be boosted by the dynamic crossing inverter 502_2.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. An inverter circuit (100; 500) comprising:
a first metal-oxide-semiconductor, in the following also referred to as MOS, transistor (M1; M11), having a control terminal configured to receive a first input signal (IN; INP) of the inverter circuit (100; 500), a first connection terminal, and a second connection terminal;
a second MOS transistor (M2; M21), having a control terminal configured to receive the first input signal (IN; INP) of the inverter circuit (100; 500), a first connection terminal, and a second connection terminal coupled to the second connection terminal of the first MOS transistor (M1; M11);
a tunable pull-up circuit (102), coupled between the first connection terminal of the first MOS transistor (M1; M11) and a first reference voltage (VDD);
a tunable pull-down circuit (104), coupled between the first connection terminal of the second MOS transistor (M2; M21) and a second reference voltage (GND); and
a control circuit (106), configured to adaptively adjust pull-up strength of the tunable pull-up circuit (102) and pull-down strength of the tunable pull-down circuit (104).

2. The inverter circuit (100; 500) of claim 1, wherein the control circuit (106) is further configured to receive an output signal (OUT) generated at the second connection terminal of the first MOS transistor (M1; M11) and the second connection terminal of the second MOS transistor (M2; M21), and adjust the pull-up strength and the pull-down strength according to the output signal (OUT).

3. The inverter circuit (100; 500) of claim 2, wherein when the output signal (OUT) has a first logic level, the pull-up strength is higher than the pull-down strength; and when the output signal (OUT) has a second logic level, the pull-up strength is lower than the pull-down strength.

4. The inverter circuit (100; 500) of claim 2 or 3, wherein the control circuit (106) comprises:
a first inverter (INV1; INV11), configured to receive a first inverter input signal (S1) derived from the output signal (OUT), and generate a first inverter output signal (S2) according to the first inverter input signal (S1); and
a second inverter (INV2; INV21), configured to receive a second inverter input signal (S3) derived from the first inverter output signal (S2), and generate a second inverter output signal (S4) according to the second inverter input signal (S3), wherein the tunable pull-up circuit (102) and the tunable pull-down circuit (104) are controlled according to the second inverter output signal (S4).

5. The inverter circuit (100; 500) of claim 4, wherein the tunable pull-up circuit (102) comprises:
a third MOS transistor (M5; M51), having a control terminal configured to receive the second inverter output signal (S4), a first connection terminal coupled to the first reference voltage (VDD), and a second connection terminal coupled to the first connection terminal of the first MOS transistor (M1; M11) ; and
the tunable pull-down circuit (104) comprises:
a fourth MOS transistor (M6; M61), having a control terminal configured to receive the second inverter output signal (S4), a first connection terminal coupled to the second reference voltage (GND), and a second connection terminal coupled to the first connection terminal of the second MOS transistor (M2; M21).

6. The inverter circuit (500) of claim 4 or 5, further comprising:
a fifth MOS transistor (M72), having a control terminal configured to receive a second input signal (INN) of the inverter circuit (500), a first connection terminal coupled to the first reference voltage (VDD), and a second connection terminal coupled to an output node of the first inverter (INV11), wherein the first input signal (INP) and the second input signal (INN) are a differential input of the inverter circuit (500); and
a sixth MOS transistor (M82), having a control terminal configured to receive the second input signal (INN) of the inverter circuit (500), a first connection terminal coupled to the second reference voltage (GND), and a second connection terminal coupled to the second connection terminal of the fifth MOS transistor (M72) and the output node of the first inverter (INV11).

7. The inverter circuit (100; 500) of any one of claims 1 to 6, wherein the inverter circuit (100; 500) is a part of a slice in a limiting amplifier.

8. A method of adaptively adjusting a crossing point of an inverter circuit, comprising:
receiving a first input signal of the inverter circuit at a control terminal of a first metal-oxide-semiconductor, in the following also referred to as MOS, transistor and a control terminal of a second MOS transistor; and
adaptively adjusting pull-up strength of a tunable pull-up circuit and pull-down strength of a tunable pull-down circuit, wherein the tunable pull-up circuit is coupled between a first connection terminal of the first MOS transistor and a first reference voltage, the tunable pull-down circuit is coupled between a first connection terminal of the second MOS transistor and a second reference voltage, and a second connection terminal of the first MOS transistor is coupled to a second connection terminal of the second MOS transistor.

9. The method of claim 8, wherein adaptively adjusting pull-up strength of the tunable pull-up circuit and pull-down strength of the tunable pull-down circuit comprises:
receiving an output signal generated at the second connection terminal of the first MOS transistor and the second connection terminal of the second MOS transistor; and
adjusting the pull-up strength and the pull-down strength according to the output signal.

10. The method of claim 9, wherein when the output signal has a first logic level, the pull-up strength is higher than the pull-down strength; and when the output signal has a second logic level, the pull-up strength is lower than the pull-down strength.

11. The method of claim 9 or 10, wherein adjusting the pull-up strength and the pull-down strength according to the output signal comprises:
generating a first inverter output signal according to a first inverter input signal that is derived from the output signal;
generating a second inverter output signal according to a second inverter input signal that is derived from the first inverter output signal; and
controlling the tunable pull-up circuit and the tunable pull-down circuit according to the second inverter output signal.

12. The method of claim 11, wherein controlling the tunable pull-up circuit and the tunable pull-down circuit according to the second inverter output signal comprises:
outputting the second inverter output signal to a control terminal of a thirdMOS transistor included in the tunable pull-up circuit, wherein a first connection terminal of the third MOS transistor is coupled to the first reference voltage, and a second connection terminal of the third MOS transistor is coupled to the first connection terminal of the first MOS transistor; and
outputting the second inverter output signal to a control terminal of a fourth MOS transistor included in the tunable pull-down circuit, wherein a first connection terminal of the fourth MOS transistor is coupled to the second reference voltage, and a second connection terminal of the fourth MOS transistor is coupled to the first connection terminal of the second MOS transistor.

13. The method of claim 11, further comprising:
receiving a second input signal of the inverter circuit at a control terminal of a third MOS transistor and a control terminal of a fourth transistor, wherein a first connection terminal of the third MOS transistor is coupled to the first reference voltage, a first connection terminal of the fourth MOS transistor is coupled to the second reference voltage, a second connection terminal of the fourth MOS transistor is coupled to a second connection terminal of the third MOS transistor, and the first input signal and the second input signal are a differential input of the inverter circuit; and
outputting the first inverter output signal to the second connection terminal of the third MOS transistor and the second connection terminal of the fourth MOS transistor.

14. The method of any one of claims 8 to 13, wherein the inverter circuit is a part of a slice in a limiting amplifier.
